# EUROPEAN PATENT APPLICATION

(11) **EP 4 481 797 A1**
(43) Date of publication of application: **25.12.2024**
(21) Application number: 24183359.9
(22) Date of filing: 20.06.2024
(51) Int. Cl.: H01L 21/3213, H01L 21/321, H01L 21/311

(54) **ETCHING COMPOSITION, METAL-CONTAINING FILM ETCHING METHOD USING THE SAME, AND SEMICONDUCTOR DEVICE MANUFACTURING METHOD USING THE SAME**

(30) Priority: 22.06.2023 KR 20230080674
(71) Applicant: Samsung Electronics Co., Ltd., Suwon-si, Gyeonggi-do 16677 (KR)
(72) Inventor: HAM, Cheol, 16678 Suwon-si (KR); KANG, Byungjoon, 16678 Suwon-si (KR); KIM, Sangwan, 16678 Suwon-si (KR); KIM, Sungmin, 16678 Suwon-si (KR); PARK, Insun, 16678 Suwon-si (KR); SONG, Gayoung, 18448 Hwaseong-si (KR); OH, Jungmin, 18448 Hwaseong-si (KR); HWANG, Kyuyoung, 16678 Suwon-si (KR)
(74) Representative: Elkington and Fife LLP

(57) **Abstract**

Provided are an etching composition, a method of etching a metal-containing film using the same, and a method of manufacturing a semiconductor device by using the same. The etching composition includes an oxidizing agent, an acid, and a selective etching inhibitor, wherein the oxidizing agent is metal-free, the selective etching inhibitor includes a copolymer including a first repeating unit and a second repeating unit, the first repeating unit is different from the second repeating unit, and the first repeating unit is a nitrogen-containing repeating unit.

## Description

### FIELD OF THE INVENTION

The disclosure relates to an etching composition, a method of etching a metal-containing film using the same, and a method of manufacturing a semiconductor device using the same.

### BACKGROUND OF THE INVENTION

To satisfy customers' demand for excellent performance and low costs, semiconductor devices may be required to have an increased degree of integration and improved reliability. As the degree of integration of a semiconductor device increases, damage to the components of a semiconductor device during a manufacturing process may have a greater impact on the reliability and electrical characteristics of a semiconductor memory device. In particular, in the semiconductor device manufacturing process, various etching processes may be performed on a certain film (e.g., a metal-containing film). To perform an effective etching process, there may be a continuous need for an etching composition capable of providing a high etch rate, excellent etching selectivity for adjacent films, absence of surface residues after etching, excellent storage stability, and the like.

### SUMMARY OF THE INVENTION

Provided is an etching composition capable of enhancing the productivity and efficiency of an etching process, while having excellent etching selectivity for a metal-containing film, which is a film to be etched.

Additional aspects will be set forth in part in the description which follows and, in part, will be apparent from the description, or may be learned by practice of the presented embodiments of the disclosure.

According to an embodiment of the disclosure, an etching composition may include an oxidizing agent, an acid, and a selective etching inhibitor. The oxidizing agent may be metal-free, and the selective etching inhibitor may include a copolymer including a first repeating unit and a second repeating unit. The first repeating unit may be different from the second repeating unit, and the first repeating unit may be a nitrogen-containing repeating unit.

In some embodiments, the oxidizing agent may be hydrogen peroxide.

In some embodiments, an amount of the oxidizing agent may be in a range of 0.1 wt% to 50 wt% with respect to 100 wt% of the etching composition.

In some embodiments, the acid may include at least one of phosphoric acid, hydrochloric acid, and chloric acid.

In some embodiments, the first repeating unit of the copolymer may include at least one of a repeating unit represented by Formula 1-1 below, a repeating unit represented by Formula 1-2 below, a repeating unit represented by Formula 1-3 below, and a repeating unit represented by Formula 1-4 below: 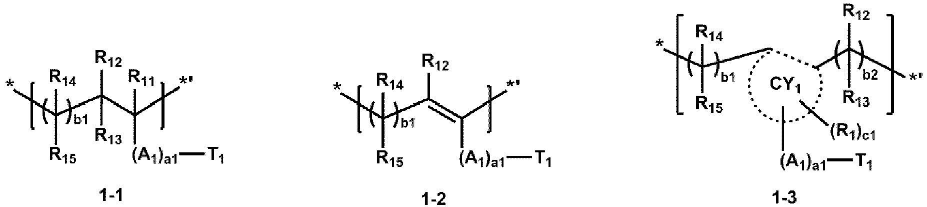 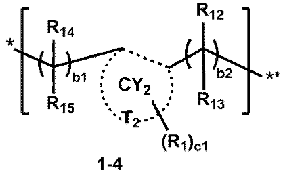
wherein A₁ in Formulae 1-1 to 1-3 may be *-C(R₁₆)(R₁₇)-*', *-N(R₁₆)-*', *-C(=O)-*', *-O-*', or *-S-*',
a1 in Formulae 1-1 to 1-3 may be an integer from 0 to 20, wherein, when a1 is 2 or greater and less than or equal to 20, at least two of A₁ may be identical to or different from each other,
b1 in Formulae 1-1 to 1-4 may be an integer from 0 to 10, wherein, when b1 is 2 or greater and less than or equal to 10, at least two of *-C(R₁₄)(R₁₅)-*' may be identical to or different from each other,
b2 in Formulae 1-3 and 1-4 may be an integer from 0 to 10, wherein, when b2 is 2 or greater and less than or equal to 10, at least two of *-C(R₁₂)(R₁₃)-*' may be identical to or different from each other,
T₁ in Formulae 1-1 to 1-3 may be *-N(Z₁₁₎(Z₁₂), *-[N(Z₁₁)(Z₁₂)(Z₁₃)⁺[Z₁₄]⁻, a group represented by Formula AN below, or a group represented by Formula BN below, 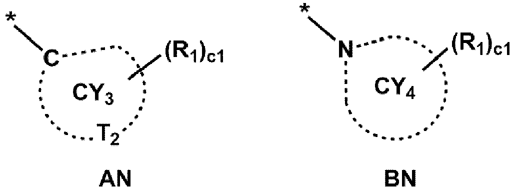
rings CY₁ to CY₄ in Formulae 1-3, 1-4, AN, and BN each independently may be a C₂-C₁₀ cyclic group,
c1 in Formulae 1-3, 1-4, AN, and BN may be an integer from 0 to 10, wherein, when c1 is 2 or greater and less than or equal to 10, at least two of R₁ may be identical to or different from each other,
T₂ in Formulae 1-4 and AN may be *-N(Z₁₁)-*' or *-[N(Z₁₁)(Z₁₂)]⁺[Z₁₄]⁻-*',
R₁, R₁₁ to R₁₇, and Z₁₁ to Z₁₃ each independently may be :
   hydrogen, deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁)(Q₂), *-[N(Q₁)(Q₂)(Q₃)]⁺[Q₄]⁻, or *-(O-CH₂CH₂)ₙ₁-OH; or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁₁)(Q₁₂), *-[N(Q₁₁)(Q₁₂)(Q₁₃)]⁺[Q₁₄]⁻, *-(O-CH₂CH₂)ₙ₁-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
   n1 may be an integer from 1 to 20,
   at least two of R₁, R₁₁ to R₁₇, and Z₁₁ to Z₁₃ may optionally be linked to each other to form a C₂-C₁₀ cyclic group,
   Q₁ to Q₃ and Q₁₁ to Q₁₃ each independently may be :
      hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
      a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
      [Z₁₄]⁻, [Q₄]⁻, and [Q₁₄]⁻ may each be an anion, and
         * and *' each denote a binding site with a neighboring atom.

In some embodiments, the first repeating unit may include the repeating unit represented by Formula 1-4 and ring CY₂ in Formula 1-4 may be a saturated cyclic group having 4, 5, 6, or 7 carbon atoms.

In some embodiments, the first repeating unit may include the repeating unit represented by Formula 1-4 and the repeating unit represented by Formula 1-4 may be a repeating unit represented by one of Formulae 1-4(1) to 1-4(3) below: 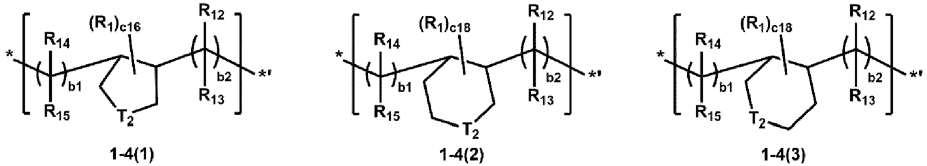
wherein, in Formulae 1-4(1) to 1-4(3),
b1, b2, R₁, R₁₂ to R₁₅, and T₂ may be the same as described herein,
c16 may be an integer from 0 to 6,
c18 may be an integer from 0 to 8, and
   * and *' each denote a binding site with a neighboring atom.

In some embodiments, the second repeating unit of the copolymer may include at least one of a repeating unit derived from a sulfur dioxide-containing compound, a repeating unit derived from an amide-containing compound, and a repeating unit derived from a carboxylic acid-containing compound.

In some embodiments, the second repeating unit of the copolymer may include at least one of a repeating unit represented by Formula 2-1 below, a repeating unit represented by Formula 2-2 below, and a repeating unit represented by Formula 2-3 below: 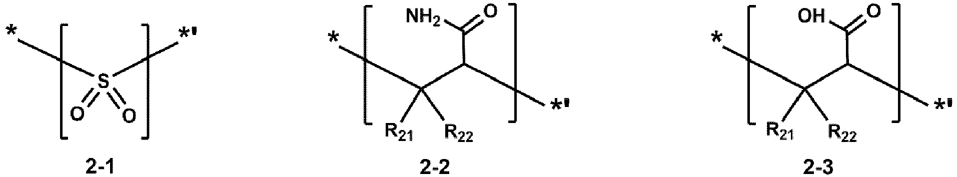
wherein, in Formulae 2-1 to 2-3,
R₂₁ and R₂₂ each independently may be :
   hydrogen, deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), or *-N(Q₂₁)(Q₂₂); or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), *-N(Q₂₁)(Q₂₂), a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
   Q₂₁ and Q₂₂ each independently may be :
      hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
      a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof, and
         * and *' each denote a binding site with a neighboring atom.

In some embodiments, the copolymer may further include a third repeating unit, in addition to the first repeating unit and the second repeating unit, and the third repeating unit may be different from each of the first repeating unit and the second repeating unit.

In some embodiments, the copolymer may have a weight average molecular weight of 200 g/mol to 100,000 g/mol.

In some embodiments, the selective etching inhibitor may further include an amine-containing compound, and the amine-containing compound may be different from the copolymer.

In some embodiments, the amine-containing compound may include an alkylamine, an alkanolamine, or any combination thereof.

In some embodiments, an amount of the selective etching inhibitor may be in a range of 0.001 wt% to 20 wt% with respect to 100 wt% of the etching composition.

In some embodiments, the etching composition may have a pH of 1.0 to 3.0.

According to an embodiment of the disclosure, a method of etching a metal-containing film may include preparing a substrate provided with a metal-containing film and performing an etching process of the metal-containing film using any one of the etching compositions described above to remove at least a portion of the metal-containing film.

In some embodiments, the metal-containing film may include indium (In), titanium (Ti), aluminum (Al), tungsten (W), lanthanum (La), scandium (Sc), gallium (Ga), zinc (Zn), hafnium (Hf), or any combination thereof.

In some embodiments, the metal-containing film may include a first region and a second region. The etching process of the metal-containing film using the etching composition may etch the first region a first etch rate and etches the second region at a second etch rate. The second etch rate may be higher than the first etch rate. The etching process may include at least a portion of the first region contacting the etching composition and at least a portion of the second region contacting the etching composition.

According to an embodiment of the disclosure, a method of manufacturing a semiconductor device may include preparing a substrate provided with a metal-containing film, performing an etching process of the metal-containing film using any one of the etching compositions described above to remove at least a portion of the metal-containing film, and performing one or more subsequent manufacturing process(es) to thereby complete forming the semiconductor device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a flowchart of an embodiment of a method of manufacturing a semiconductor device; and
FIGS. 2 and 3 are schematic views for explaining an embodiment of a method of etching a metal-containing film.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, "at least one of A, B, and C," and similar language (e.g., "at least one selected from the group consisting of A, B, and C") may be construed as A only, B only, C only, or any combination of two or more of A, B, and C, such as, for instance, ABC, AB, BC, and AC.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

### Film to be etched

A film to be etched may include a metal-containing film.

Thus, an etching composition may be used in an etching process and/or chemical mechanical polishing (CMP) process of the metal-containing film.

A metal included in the metal-containing film may include an alkali metal (e.g., sodium (Na), potassium (K), rubidium (Rb), cesium (Cs), or the like), an alkaline earth metal (e.g., beryllium (Be), magnesium (Mg), calcium (Ca), strontium (Sr), barium (Ba), or the like), a lanthanum metal (e.g., lanthanum (La), europium (Eu), terbium (Tb), ytterbium (Yb) ), or the like), a transition metal (e.g., scandium (Sc), yttrium (Y), titanium (Ti), zirconium (Zr), hafnium (Hf), vanadium (V), niobium (Nb), tantalum (Ta), chromium (Cr), molybdenum (Mo), tungsten (W), manganese (Mn), iron (Fe), ruthenium (Ru), osmium (Os), cobalt (Co), rhodium (Rh), nickel (Ni), copper (Cu), silver (Ag), zinc (Zn), or the like), a post-transition metal (e.g., aluminum (Al), gallium (Ga), indium (In), thallium (Tl), tin (Sn), bismuth (Bi), or the like), or any combination thereof.

According to an embodiment, the metal-containing film may include In, Ti, Al, Cu, W, Co, La, Sc, Ga, Zn, Hf, or any combination thereof.

According to an embodiment, the metal-containing film may include In, Ti, Al, W, La, Sc, Ga, Zn, Hf, or any combination thereof.

For example, the metal-containing film may include aluminum, titanium, lanthanum, tungsten, or any combination thereof.

In an embodiment, the metal-containing film may include titanium.

In an embodiment, the metal-containing film may include titanium and aluminum.

In an embodiment, the metal-containing film may include tungsten.

The metal-containing film may include a metal, a metal nitride, a metal oxide, a metal oxynitride, or any combination thereof.

The metal-containing film may include a metal, a metal nitride, a metal oxide, a metal oxynitride, or any combination thereof, and a metal included in each of the metal, the metal nitride, the metal oxide, and the metal oxynitride may include In, Ti, Al, La, Sc, Ga, Zn, Hf, or any combination thereof.

The metal-containing film may include a metal nitride. A metal included in the metal nitride may include indium, titanium, aluminum, lanthanum, scandium, gallium, zinc, hafnium, or any combination thereof.

For example, the metal-containing film may include a metal, for example, tungsten.

In an embodiment, the metal-containing film may include titanium nitride. The titanium nitride may further include indium, aluminum, lanthanum, scandium, gallium, hafnium, zinc, or any combination thereof. In an embodiment, the metal-containing film may include titanium nitride (TiN), titanium nitride further including aluminum (e.g., titanium/aluminum nitride or TiAlN), titanium nitride further including lanthanum, or the like.

In an embodiment, the metal-containing film may include a metal oxide. A metal included in the metal oxide may include titanium, aluminum, lanthanum, scandium, gallium, hafnium, or any combination thereof. For example, the metal-containing film may include aluminum oxide (e.g., Al₂O₃), indium gallium zinc oxide (IGZO), or the like.

In an embodiment, the metal-containing film may include the metal and the metal nitride.

In an embodiment, the metal-containing film may further include, in addition to the metal, a metalloid (e.g., boron (B), silicon (Si), germanium (Ge), arsenic (As), antimony (Sb), tellurium (Te), or the like), a non-metal (e.g., nitrogen (N), phosphorus (P), oxygen (O), sulfur (S), selenium (Se), or the like), or any combination thereof.

For example, the metal-containing film may further include silicon oxide.

The metal-containing film may have a single-layered structure consisting of (or including) one or more types of materials, or may have a multi-layered structure or patterned structure including different materials. For example, the metal-containing film may have i) a single-layered structure consisting of (or including) titanium nitride, ii) a double-layered structure or patterned structure including: a first layer consisting of (or including) titanium nitride; and a second layer consisting of (or including) titanium nitride further including aluminum, iii) a double-layered structure or patterned structure including: a first layer consisting of (or including) titanium nitride; and a second layer consisting of (or including) aluminum oxide, iv) a double-layered structure or patterned structure including: a first layer consisting of (or including) titanium nitride; and a second layer consisting of (or including) tungsten, or the like.

According to an embodiment, the metal-containing film may include a first region and a second region, and a second etch rate at which the second region is etched by the etching composition may be higher than a first etch rate at which the first region is etched by the etching composition. During the etching process and/or polishing process of the metal-containing film, at least a portion of the first region and at least a portion of the second region may come into contact with the etching composition, and since the second etch rate is higher than the first etch rate, the second region may be etched faster than the first region.

For example, the first region may include at least one of a metal, a metal oxide (e.g., aluminum oxide), and silicon oxide.

According to an embodiment, the first region may include tungsten.

In an embodiment, the second region may include a metal nitride.

In an embodiment, the second region may include i) titanium nitride, ii) titanium nitride further including indium, aluminum, lanthanum, scandium, gallium, zinc, hafnium, or any combination thereof, or iii) a combination thereof.

In an embodiment, each of the first region and the second region may include i) titanium nitride, ii) titanium nitride further including indium, aluminum, lanthanum, scandium, gallium, zinc, hafnium, or any combination thereof, or iii) a combination thereof.

In an embodiment, the first region may include aluminum, and the second region may be aluminum-free.

In an embodiment, the first region may include titanium nitride further including aluminum (e.g., titanium/aluminum nitride or TiAlN), and the second region may include titanium nitride (TiN).

In an embodiment, the first region may include a titanium nitride film further including aluminum (e.g., a titanium/aluminum nitride film or a TiAlN film), and the second region may include a titanium nitride (TiN) film.

In an embodiment, the first region may be a titanium nitride film further including aluminum (e.g., a titanium/aluminum nitride film or a TiAlN film), and the second region may be a titanium nitride (TiN) film.

In an embodiment, the first region may include tungsten, and the second region may be tungsten-free.

In an embodiment, the first region may include tungsten, and the second region may include titanium nitride (TiN).

In an embodiment, the first region may include a tungsten film, and the second region may include a titanium nitride (TiN) film.

In an embodiment, the first region may be a tungsten film, and the second region may be a titanium nitride (TiN) film.

The expression "a certain layer is etched" as used herein may mean that at least some of materials constituting the film are removed.

### Etching composition

The etching composition may include an oxidizing agent, an acid, and a selective etching inhibitor.

The etching composition may be used in an etching process and/or chemical mechanical polishing (CMP) process of a film to be etched described herein, for example, a metal-containing film.

The etching composition may further include water.

According to an embodiment, the etching composition may consist of an oxidizing agent, an acid, a selective etching inhibitor, and water.

According to an embodiment, the etching composition may be free of copper ions, nitric acid, sulfonic acid, a fluorine compound (e.g., hydrofluoric acid, ammonium fluoride, ammonium bifluoride, hexafluoride silicic acid, ammonium silicon hexafluoride, ammonium tetrafluoroborate, or the like), and a phosphine-based compound.

### Oxidizing agent

The oxidizing agent serves to etch the metal-containing film, and is free of a metal (e.g., metal ions or the like).

For example, the oxidizing agent may include at least one of hydrogen peroxide, nitric acid, and ammonium sulfate.

According to an embodiment, the oxidizing agent may be hydrogen peroxide.

According to an embodiment, the amount (weight) of the oxidizing agent may be, for example, with respect to 100 wt% of the etching composition, in a range of about 0.001 wt% to about 50 wt%, about 0.001 wt% to about 40 wt%, about 0.001 wt% to about 30 wt%, about 0.001 wt% to about 20 wt%, about 0.001 wt% to about 10 wt%, about 0.01 wt% to about 50 wt%, about 0.01 wt% to about 40 wt%, about 0.01 wt% to about 30 wt%, about 0.01 wt% to about 20 wt%, about 0.01 wt% to about 10 wt%, about 0.1 wt% to about 50 wt%, about 0.1 wt% to about 40 wt%, about 0.1 wt% to about 30 wt%, about 0.1 wt% to about 20 wt%, about 0.1 wt% to about 10 wt%, about 0.5 wt% to about 50 wt%, about 0.5 wt% to about 40 wt%, about 0.5 wt% to about 30 wt%, about 0.5 wt% to about 20 wt%, about 0.5 wt% to about 10 wt%, about 1.0 wt% to about 50 wt%, about 1.0 wt% to about 40 wt%, about 1.0 wt% to about 30 wt%, about 1.0 wt% to about 20 wt%, about 1.0 wt% to about 10 wt%, about 3.0 wt% to about 50 wt%, about 3.0 wt% to about 40 wt%, about 3.0 wt% to about 30 wt%, about 3.0 wt% to about 20 wt%, about 3.0 wt% to about 10 wt%, about 5.0 wt% to about 50 wt%, about 5.0 wt% to about 40 wt%, about 5.0 wt% to about 30 wt%, about 5.0 wt% to about 20 wt%, or about 5.0 wt% to about 10 wt%.

### Acid

The acid may serve to etch the metal-containing film, together with the oxidizing agent.

The acid may include a phosphorus-based inorganic acid, a chlorine-based inorganic acid, a fluorine-based inorganic acid, or any combination thereof.

For example, the acid may be free of at least one of nitric acid and sulfuric acid.

For example, the acid may include at least one of a phosphorus-based inorganic acid and a chlorine-based inorganic acid.

According to an embodiment, the acid may include at least one of phosphoric acid, hydrochloric acid, and chloric acid.

The amount (weight) of the acid may be, for example, with respect to 100 wt% of the etching composition, in a range of about 0.01 wt% to about 90 wt%, about 0.1 wt% to about 90 wt%, about 1.0 wt% to about 90 wt%, about 10 wt% to about 90 wt%, about 20 wt% to about 90 wt%, about 30 wt% to about 90 wt%, about 40 wt% to about 90 wt%, about 50 wt% to about 90 wt%, about 0.01 wt% to about 80 wt%, about 0.1 wt% to about 80 wt%, about 1.0 wt% to about 80 wt%, about 10 wt% to about 80 wt%, about 20 wt% to about 80 wt%, about 30 wt% to about 80 wt%, about 40 wt% to about 80 wt%, about 50 wt% to about 80 wt%, about 0.01 wt% to about 70 wt%, about 0.1 wt% to about 70 wt%, about 1.0 wt% to about 70 wt%, about 10 wt% to about 70 wt%, about 20 wt% to about 70 wt%, about 30 wt% to about 70 wt%, about 40 wt% to about 70 wt%, or about 50 wt% to about 70 wt%.

According to an embodiment, the acid may be an organic acid, for example, acetic acid, tartaric acid, benzoic acid, or the like.

### Selective etching inhibitor

The selective etching inhibitor may serve to control an etch rate or the like by interacting with metal atoms (e.g., titanium atoms) in the metal-containing film, which is a film to be etched.

The selective etching inhibitor may include a copolymer including a first repeating unit and a second repeating unit. The copolymer may be a water-soluble copolymer. The number of different repeating units included in the copolymer may be 2 or greater.

The first repeating unit may be different from the second repeating unit.

The first repeating unit may be a nitrogen-containing repeating unit.

According to an embodiment, the first repeating unit may be a repeating unit derived from a nitrogen-containing ethylene-based unsaturated compound. The nitrogen-containing ethylene-based unsaturated compound may include dialkylaminoalkyl acrylate, dialkylaminoalkyl methacrylate, dialkylaminoalkylacrylamide, dialkylaminoalkyl methacrylamide, allyl amine, diallylamine, dimethylallylamine, methyldiallylamine, 2-vinylpyridine, 4-vinylpyridine, N',N'-dimethylaminoethyl-N,N-dimethylammonium-N-propyl methacrylate chloride, or any combination thereof. The term "alkyl" as used herein may refer to a C₁-C₅₀ alkyl group.

According to an embodiment, the first repeating unit may include at least one of a repeating unit represented by Formula 1-1 below, a repeating unit represented by Formula 1-2 below, a repeating unit represented by Formula 1-3 below, and a repeating unit represented by Formula 1-4 below: 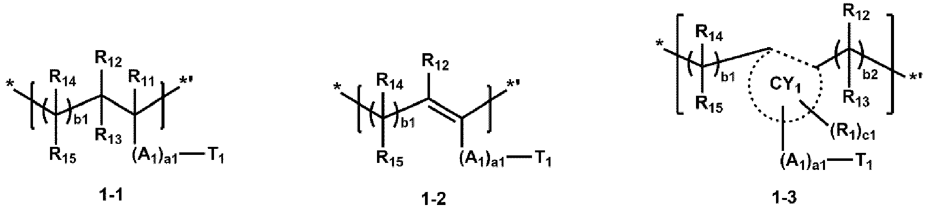 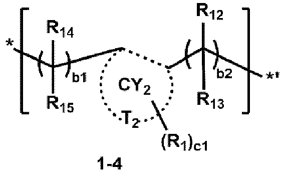
A₁ in Formulae 1-1 to 1-3 may be *-C(R₁₆)(R₁₇)-*', *-N(R₁₆)-*', *-C(=O)-*', *-O-*', or *-S-*'.
a1 in Formulae 1-1 to 1-3 may be an integer from 0 to 20, wherein, when a1 is 2 or greater and less than or equal to 20, at least two of A₁ may be identical to or different from each other. When a1 is 0, *-(A₁)ₐ₁-*' may be a single bond.

According to an embodiment, a1 may be 0.

According to an embodiment, a1 may not be 0.

According to an embodiment, a1 may be an integer from 0 to 10.

According to an embodiment, a1 may be an integer from 1 to 5.
b1 in Formulae 1-1 to 1-4 may be an integer from 0 to 10, wherein, when b1 is 2 or greater and less than or equal to 10, at least two of *-C(R₁₄)(R₁₅)-*' may be identical to or different from each other. When b1 is 0, *-C(R₁₄)(R₁₅)-*' may be a single bond.
b2 in Formulae 1-3 to 1-4 may be an integer from 0 to 10, wherein, when b2 is 2 or greater and less than or equal to 10, at least two of *-C(R₁₂)(R₁₃)-*' may be identical to or different from each other. When b2 is 0, *-C(R₁₂)(R₁₃)-*' may be a single bond.

According to an embodiment, b1 may be an integer from 1 to 5.

According to an embodiment, b2 may be an integer from 0 to 2.

According to an embodiment, b1 and b2 in Formulae 1-3 and 1-4 may each be 1.

T₁ in Formulae 1-1 to 1-3 may be *-N(Z₁₁₎(Z₁₂), *-[N(Z₁₁)(Z₁₂)(Z₁₃)⁺[Z₁₄]⁻, a group represented by Formula AN below, or a group represented by Formula BN below:

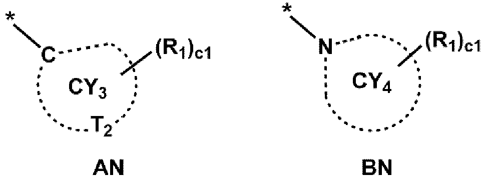

Rings CY₁ to CY₄ in Formulae 1-3, 1-4, AN, and BN each independently may be a C₂-C₁₀ cyclic group.

According to an embodiment, T₁ in Formulae 1-1 to 1-3 may be *-N(Z₁₁)(Z₁₂) or *-[N(Z₁₁)(Z₁₂)(Z₁₃)]⁺[Z₁₄]⁻, and Z₁₁ to Z₁₃ may each be hydrogen.

According to an embodiment, T₁ in Formulae 1-1 to 1-3 may be *-N(Z₁₁)(Z₁₂) or *-[N(Z₁₁)(Z₁₂)(Z₁₃)⁺[Z₁₄]⁻, and Z₁₁ may be hydrogen and Z₁₂ may not be hydrogen.

According to an embodiment, T₁ in Formulae 1-1 to 1-3 may be *-N(Z₁₁)(Z₁₂) or *-[N(Z₁₁)(Z₁₂)(Z₁₃)]⁺[Z₁₄]⁻, and each of Z₁₁ and Z₁₂ may not be hydrogen.

According to an embodiment, T₁ in Formulae 1-1 to 1-3 may be *-[N(Z₁₁)(Z₁₂)(Z₁₃)⁺[Z₁₄]⁻, and each of Z₁₁ to Z₁₃ may not be hydrogen.

According to an embodiment, T₁ in Formulae 1-1 to 1-3 may be a group represented by Formula AN, and Z₁₁ and Z₁₂ in T₂ of Formula AN may be hydrogen.

According to an embodiment, T₁ in Formulae 1-1 to 1-3 may be a group represented by Formula AN, and Z₁₁ in T₂ of Formula AN may not be hydrogen.

According to an embodiment, T₁ in Formulae 1-1 to 1-3 may be a group represented by Formula AN, and T₂ in Formula AN may be *-[N(Z₁₁)(Z₁₂)⁺[Z₁₄]⁻-*', wherein each of Z₁₁ and Z₁₂ may not be hydrogen.

According to an embodiment, in T₂ of Formula 1-4, Z₁₁ and Z₁₂ may each be hydrogen.

According to an embodiment, in T₂ of Formula 1-4, Z₁₁ may not be hydrogen, and Z₁₂ may be hydrogen.

According to an embodiment, T₂ of Formula 1-4 may be *-[N(Z₁₁)(Z₁₂)]⁺[Z₁₄]⁻-*', and each of Z₁₁ and Z₁₂ may not be hydrogen.

In Formulae 1-3, 1-4, AN, and BN, c1 refers to the number of R₁, and may be an integer from 0 to 10. When c1 is 2 or greater and less than or equal to 10, at least two of R₁ may be identical to or different from each other.

In Formula 1-4 and AN, T₂ may be *-N(Z₁₁)-*' or *-[N(Z₁₁)(Z₁₂)]⁺[Z₁₄]⁻-*'. Details on Z₁₁, Z₁₂, and Z₁₄ are referred to the descriptions provided herein.

According to an embodiment, CY₁ in Formula 1-3 may be a cyclopropane group, a cyclobutane group, a cyclopentane group, a cyclohexane group, a cycloheptane group, a cyclooctane group, an oxirane group, an oxetane group, a tetrahydrofuran group, or a tetrahydropyran group.

According to an embodiment, ring CY₂ in Formula 1-4 may be a saturated cyclic group having 4, 5, 6, or 7 carbon atoms.

According to an embodiment, in Formula AN,
i) T₂ may be *-N(Z₁₁)-*', and ring CY₃ may be a pyrrole group, an imidazole group, a pyrazole group, an aziridine group, an azetidine group, a pyrrolidine group, or a piperidine group, or
ii) T₂ may be *-[N(Z₁₁)(Z₁₂)⁺[Z₁₄]⁻-*', and ring CY₃ may be a saturated cyclic group having 4, 5, 6 or 7 carbon atoms.

According to an embodiment, ring CY₄ in Formula BN may be a pyrrole group, an imidazole group, a pyrazole group, an aziridine group, an azetidine group, a pyrrolidine group, or a piperidine group.

R₁, R₁₁ to R₁₇, and Z₁₁ to Z₁₃ each independently may be :
hydrogen, deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁)(Q₂), *-[N(Q₁)(Q₂)(Q₃)]⁺[Q₄]⁻, or *-(O-CH₂CH₂)ₙ₁-OH; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁₁)(Q₁₂), *-[N(Q₁₁)(Q₁₂)(Q₁₃)]⁺[Q₁₄]⁻, *-(O-CH₂CH₂)ₙ₁-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof.

For example, R₁, R₁₁ to R₁₇, and Z₁₁ to Z₁₃ each independently may be:
hydrogen, deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁)(Q₂), *-[N(Q₁)(Q₂)(Q₃)]⁺[Q₄]⁻, or *-(O-CH₂CH₂)ₙ₁-OH; or
a C₁-C₁₀ alkyl group unsubstituted or substituted with deuterium, *-F, *-Cl, *-Br, *-I, *-OH, *-SH, *-C(=O)-Q₁, *-NH-C(=O)-Q₁, *-C(=O)-O-Q₁, *-SQ₂-Q₁, *-P(=O)-(Q₁)(Q₂), *-N(Q₁₁)(Q₁₂), *-[N(Q₁₁)(Q₁₂)(Q₁₃)]⁺[Q₁₄]⁻, *-(O-CH₂CH₂)ₙ₁-OH, a C₁-C₁₀ alkyl group, or any combination thereof.
n1 may be an integer from 1 to 20.

At least two of R₁, R₁₁ to R₁₇, and Z₁₁ to Z₁₃ may optionally be linked to each other to form a C₂-C₁₀ cyclic group.

Q₁ to Q₃ and Q₁₁ to Q₁₃ each independently may be :
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof.

The C₃-C₃₀ carbocyclic group may be, for example, a cyclopropyl group, a cyclobutyl group, a cyclopentyl group, a cyclohexyl group, a cycloheptyl group, a cyclooctyl group, a phenyl group, a naphthyl group, or the like.

The C₁-C₃₀ heterocyclic group may be, for example, an oxiranyl group, an oxetanyl group, a tetrahydrofuranyl group, a tetrahydropyranyl group, a pyridinyl group, a pyrimidinyl group, or the like.

[Z₁₄]⁻, [Q₄]⁻; and [Q₁₄]⁻ may each be an anion.

For example, [Z₁₄]⁻, [Q₄]⁻, and [Q₁₄]⁻ each independently may be hydroxide ([OH]⁻), borate ([B(OH)₄]⁻), fluoride ([F]⁻), chloride ([Cl]⁻), bromide ([Br]⁻), iodide ([I]⁻), hydrogen sulfate ([HSO₄]⁻), nitrate ([NO₃]⁻), formate ([HCOO]⁻), acetate ([CH₃COO]⁻), dihydrogen phosphate (H₂PO₄]⁻), alkylsulfate (e.g., ethyl sulfate ([C₂H₅SO₄]⁻)), or sulfamate ([NH₂SO₃]⁻).

In the specification, * and *' each denote to a binding site with a neighboring atom, unless otherwise defined.

According to an embodiment, the repeating unit represented by Formula 1-3 may be a repeating unit represented by one of Formulae 1-3(1) to 1-3(8): 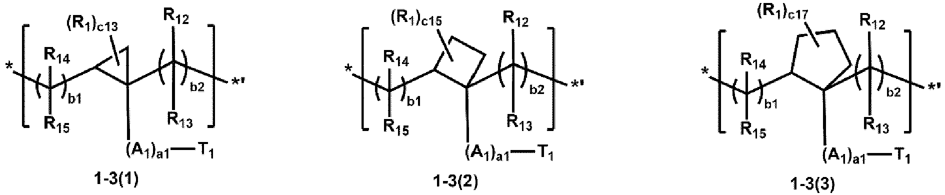 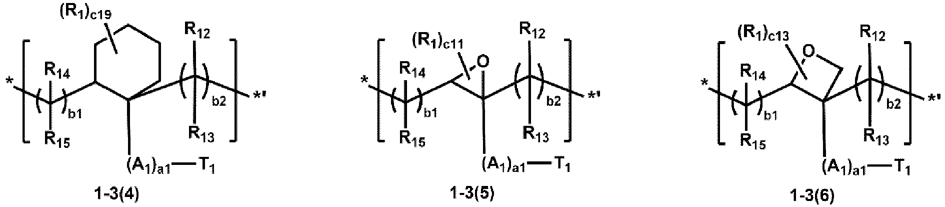 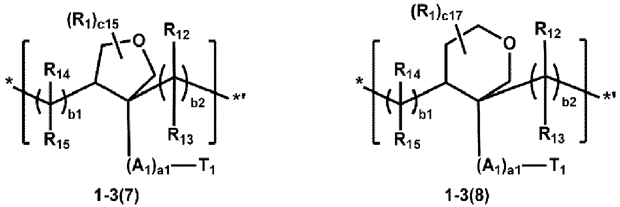
wherein, in Formulae 1-3(1) to 1-3(8),
A₁, a1, b1, b2, T₁, R₁, and R₁₂ to R₁₅ are each the same as described herein, c11 may be 0 or 1,
c13 may be an integer from 0 to 3,
c15 may be an integer from 0 to 5,
c17 may be an integer from 0 to 7,
c19 may be an integer from 0 to 9, and
   * and *' each denote a binding site with a neighboring atom.

According to an embodiment, the repeating unit represented by Formula 1-4 may be a repeating unit represented by one of Formulae 1-4(1) to 1-4(3) below: 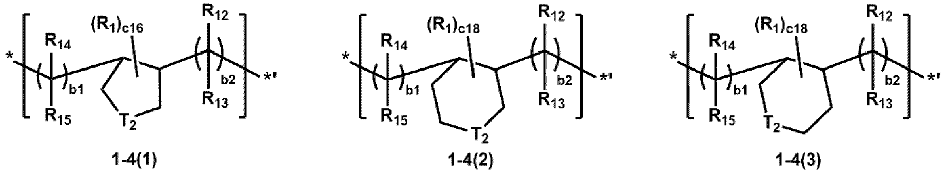
wherein, in Formulae 1-4(1) to 1-4(3),
b1, b2, R₁, R₁₂ to R₁₅, and T₂ are each the same as described herein,
c16 may be an integer from 0 to 6,
c18 may be an integer from 0 to 8, and
   * and *' each denote a binding site with a neighboring atom.

According to an embodiment, the group represented by Formula AN may be a group represented by one of Formulae AN(1) to AN(12) below: 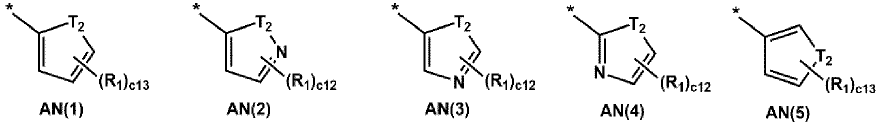 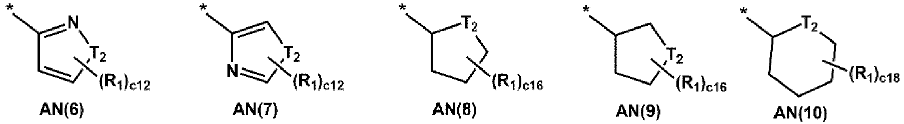 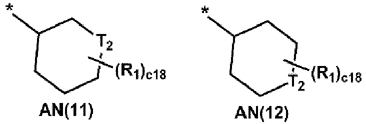
wherein, in Formulae AN(1) to AN(12),
R₁ and T₂ are each the same as described herein,
c12 may be an integer from 0 to 2,
c13 may be an integer from 0 to 3,
c16 may be an integer from 0 to 6,
c18 may be an integer from 0 to 8, and
   * denotes to a binding site with a neighboring atom.

According to an embodiment, the group represented by Formula BN may be a group represented by one of Formulae BN(1) to BN(7) below: 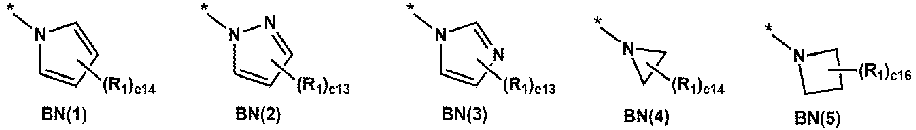 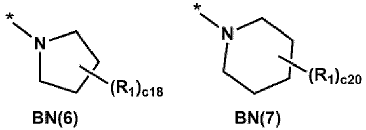
wherein, in Formulae BN(1) to BN(7),
R₁ is the same as described herein,
c13 may be an integer from 0 to 3,
c14 may be an integer from 0 to 4,
c16 may be an integer from 0 to 6,
c18 may be an integer from 0 to 8,
c20 may be an integer from 0 to 10, and
   * denotes to a binding site with a neighboring atom.

The second repeating unit of the copolymer may include at least one of a repeating unit derived from a sulfur dioxide-containing compound, a repeating unit derived from an amide-containing compound, and a repeating unit derived from a carboxylic acid-containing compound. For example, the amide-containing compound may include acrylamide (CH₂=CHC(O)NH₂), methacrylamide (CH₂=C(CH₃)C(O)NH₂), diacetone acrylamide, N,N-dimethylacrylamide, or any combination thereof. In addition, the carboxylic acid-containing compound may include acrylic acid or acrylate derived from an alcohol having 1 to 30 carbon atoms, methacrylic acid or methacrylate derived from an alcohol having 1 to 30 carbon atoms, an unsaturated dicarboxylic acid having 1 to 30 carbon atoms (e.g., maleic acid), or any combination thereof.

According to an embodiment, the second repeating unit may include at least one of a repeating unit represented by Formula 2-1 below, a repeating unit represented by Formula 2-2 below, and a repeating unit represented by Formula 2-3 below: 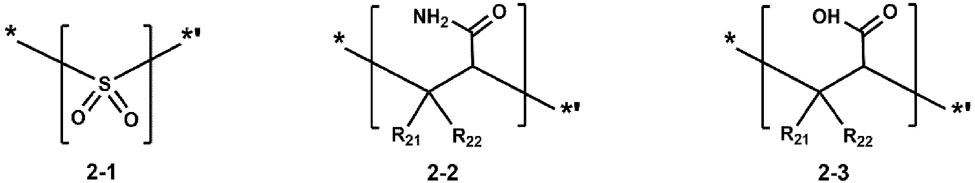
wherein, in Formulae 2-1 to 2-3,
R₂₁ and R₂₂ each independently may be :
   hydrogen, deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), or *-N(Q₂₁)(Q₂₂); or
   a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), *-N(Q₂₁)(Q₂₂), a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
   Q₂₁ and Q₂₂ each independently may be :
      hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
      a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof, and
         * and *' each denote a binding site with a neighboring atom.

For example, R₂₁ and R₂₂ each independently may be:
hydrogen, deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), or *-N(Q₂₁)(Q₂₂); or
a C₁-C₁₀ alkyl group unsubstituted or substituted with deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), *-N(Q₂₁)(Q₂₂), a C₁-C₁₀ alkyl group, or any combination thereof.

For example, Q₂₁ and Q₂₂ each independently may be:
hydrogen, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₁₀ alkyl group unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₁₀ alkyl group, or any combination thereof.

A molar ratio of the first repeating unit to the second repeating unit in the copolymer may be in a range of about 1:99 to about 99:1, about 10:90 to about 90:10, about 20:80 to about 80:20, about 30:70 to about 70:30, or about 40:60 to about 60:40.

According to an embodiment, the copolymer may further include a third repeating unit, and the third repeating unit may be different from each of the first repeating unit and the second repeating unit.

For example, the third repeating unit may include at least one of a repeating unit derived from a sulfur dioxide-containing compound, a repeating unit derived from an amide-containing compound, and a repeating unit derived from a carboxylic acid-containing compound. Details on the amide-containing compound and the carboxylic acid-containing compound may be referred to the descriptions provided herein.

In an embodiment, the third repeating unit may include at least one of a repeating unit represented by Formula 2-1 above, a repeating unit represented by Formula 2-2 above, and a repeating unit represented by Formula 2-3 above.

The copolymer may be an alternating copolymer, a block copolymer, a random copolymer, or a graft copolymer.

The copolymer may have a weight average molecular weight of about 200 g/mol to about 100,000 g/mol.

According to an embodiment, the copolymer may be at least one of a diallyldimethyl-ammoniumchloride sulfur dioxide copolymer, a diallylamine sulfur dioxide copolymer, a diallylamine hydrochloride sulfur dioxide copolymer, a diallylmethylethyl-ammoniumethylsulfate sulfur dioxide copolymer, a diallylamine acetate sulfur dioxide copolymer, a methyldiallylamine hydrochloride sulfur dioxide copolymer, a diallylamine acrylamide copolymer, a diallylamine hydrochloride acrylamide copolymer, a diallyldimethyl-ammoniumchloride acrylamide copolymer, a diallylamine maleic acid copolymer, a diallylamine hydrochloride maleic acid copolymer, a diallylamine amidesulfate maleic acid copolymer (or, a diallylamine sulfamate maleic acid copolymer), a methyldiallylamine maleic acid copolymer, a diallylmethylethyl-ammoniumethylsulfate maleic acid copolymer, a diallyldimethyl ammoniumchloride maleic acid copolymer, a diallylamine maleic acid sulfur dioxide copolymer, a diallyldimethyl ammoniumchloride maleic acid sulfur dioxide copolymer, and an allylamine maleic acid copolymer.

According to an embodiment, the copolymer may be at least one of Polymers 1 to 18 below: 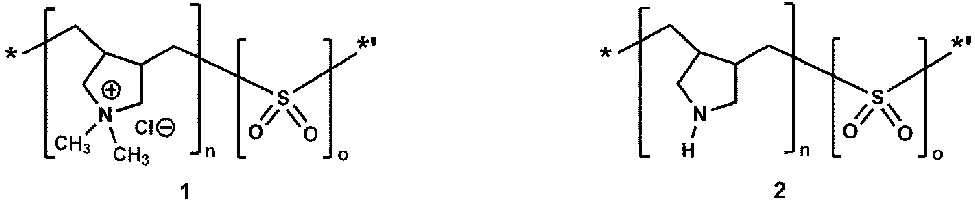 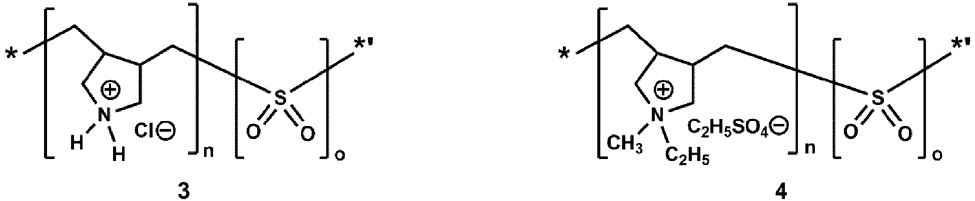 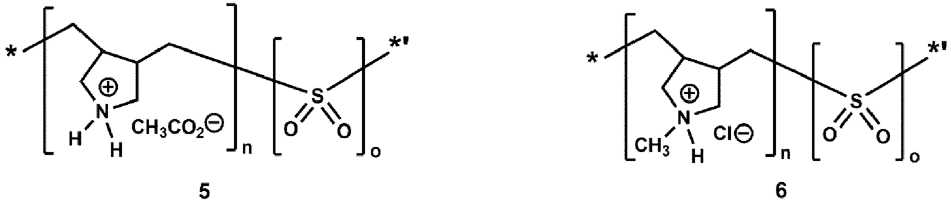 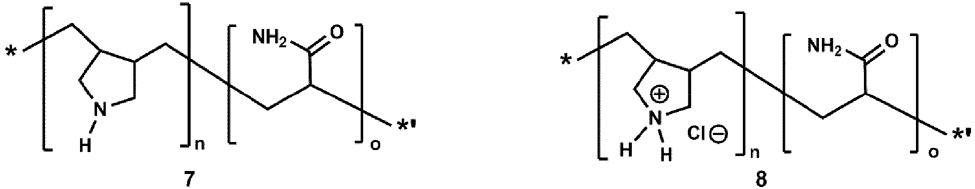 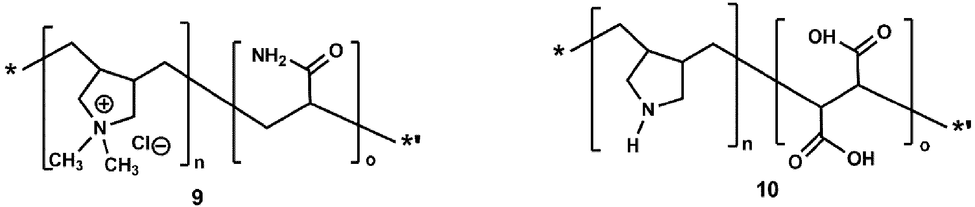 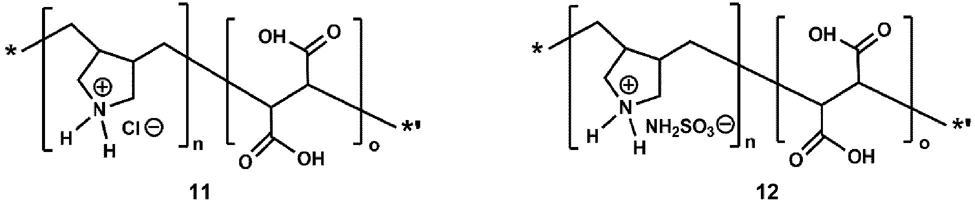 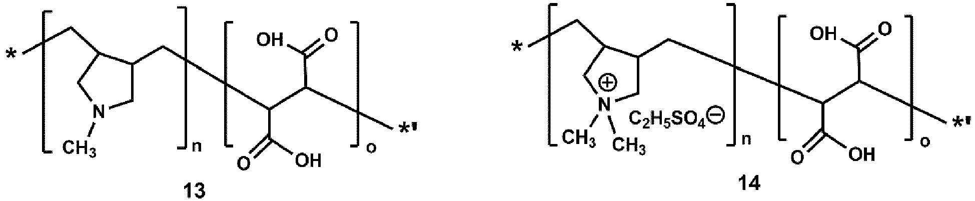 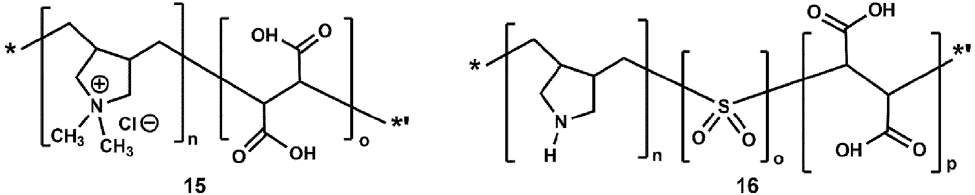 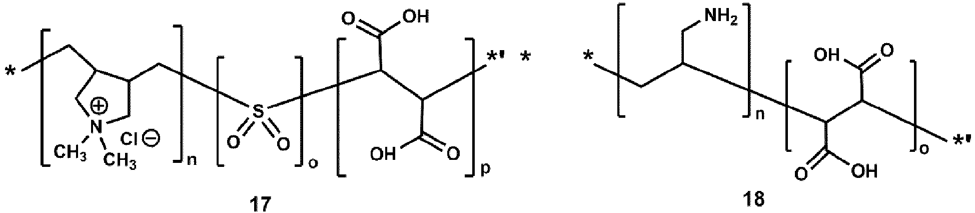
wherein, in Polymers 1 to 18,
n, o, and p each independently may be selected from 1 to 10,000, and
   * and *' each denote a binding site with a neighboring atom.

In Polymers 1 to 18, n, o, and p each independently may be integers from 1 to 10,000.

Polymers 1 to 18 may have a weight average molecular weight within the range described herein.

The etching composition including the copolymer as described above may enhance the productivity and efficiency of the etching process, while having excellent selectivity for the metal-containing film.

The selective etching inhibitor may further include an amine-containing compound different from the copolymer. By further including the amine-containing compound, adjustment of the etch rate of the metal-containing film and the etching selectivity therefor may be effectively controlled.

According to an embodiment, the amine-containing compound may include an alkylamine, an alkanolamine, or any combination thereof.

According to an embodiment, the amine-containing compound may include a monoalkylamine (e.g., monobutylamine), a monoalkanolamine (e.g., ethanolamine), or any combination thereof.

According to an embodiment, the amine-containing compound may include a compound represented by Formula 5 below:

Formula 5 N(Q₅₁)(Q₅₂)(Q₅₃)

wherein, in Formula 5, Q₅₁ to Q₅₃ each independently may be:
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
and at least one of Q₅₁ to Q₅₃ may not be hydrogen.

For example, in Formula 5, Q₅₁ and Q₅₂ may each be hydrogen, and Q₅₃ may be: a C₁-C₂₀ alkyl group; or a C₁-C₂₀ alkyl group substituted with deuterium, *-F, *-OH, or any combination thereof.

When the selective etching inhibitor further includes an amine-containing compound, a weight ratio of the copolymer to the amine-containing compound may be in a range of about 100:1 to about 1:100.

The amount (weight) of the selective etching inhibitor may be, on the basis of solids of the selective etching inhibitor, for example, with respect to 100 wt% of the etching composition, in a range of about 0.001 wt% to about 20 wt%, about 0.001 wt% to about 15 wt%, about 0.001 wt% to about 10 wt%, about 0.001 wt% to about 7 wt%, about 0.001 wt% to about 5 wt%, about 0.001 wt% to about 4 wt%, about 0.001 wt% to about 3 wt%, about 0.001 wt% to about 2 wt%, about 0.001 wt% to about 1 wt%, about 0.001 wt% to about 0.5 wt%, about 0.001 wt% to about 0.3 wt%, about 0.005 wt% to about 20 wt%, about 0.005 wt% to about 15 wt%, about 0.005 wt% to about 10 wt%, about 0.005 wt% to about 7 wt%, about 0.005 wt% to about 5 wt%, about 0.005 wt% to about 4 wt%, about 0.005 wt% to about 3 wt%, about 0.005 wt% to about 2 wt%, about 0.005 wt% to about 1 wt%, about 0.005 wt% to about 0.5 wt%, about 0.005 wt% to about 0.3 wt%, about 0.01 wt% to about 20 wt%, about 0.01 wt% to about 15 wt%, about 0.01 wt% to about 10 wt%, about 0.01 wt% to about 7 wt%, about 0.01 wt% to about 5 wt%, about 0.01 wt% to about 4 wt%, about 0.01 wt% to about 3 wt%, about 0.01 wt% to about 2 wt%, about 0.01 wt% to about 1 wt%, about 0.01 wt% to about 0.5 wt%, about 0.01 wt% to 0.3 wt%, about 0.05 wt% to about 20 wt%, about 0.05 wt% to about 15 wt%, about 0.05 wt% to about 10 wt%, about 0.05 wt% to about 7 wt%, about 0.05 wt% to about 5 wt%, about 0.05 wt% to about 4 wt%, about 0.05 wt% to about 3 wt%, about 0.05 wt% to about 2 wt%, about 0.05 wt% to about 1 wt%, about 0.05 wt% to about 0.5 wt%, about 0.05 wt% to about 0.3 wt%, about 0.1 wt% to about 20 wt%, about 0.1 wt% to about 15 wt%, about 0.1 wt% to about 10 wt%, about 0.1 wt% to about 7 wt%, about 0.1 wt% to about 5 wt%, about 0.1 wt% to about 4 wt%, about 0.1 wt% to about 3 wt%, about 0.1 wt% to about 2 wt%, about 0.1 wt% to about 1 wt%, about 0.1 wt% to about 0.5 wt%, or about 0.1 wt% to about 0.3 wt%.

The etching composition as described above may have a pH of about 1.0 to about 8.0, about 1.0 to about 7.0, about 1.0 to about 6.0, about 1.0 to about 5.0, about 1.0 to about 4.0, about 1.0 to about 3.0, about 2.0 to about 8.0, about 2.0 to about 7.0, about 2.0 to about 6.0, about 2.0 to about 5.0, about 2.0 to about 4.0, or about 2.0 to about 3.0. When the pH of the etching composition is within the above range, the interaction between the selective etching inhibitor and metal atoms in the metal-containing film, which will be described below, may occur more smoothly.

For example, the etching composition may have a pH of about 1.0 to about 3.0.

According to an embodiment, the etching composition may be used in an etching process and/or CMP process of the metal-containing film. Details on the metal-containing film may be referred to the descriptions provided herein.

In one or more embodiments, the etching composition may be used as an agent for removing etch by-products, an agent for removing post-etch by-products, an agent for removing ashing by-products, a cleaning composition, a photoresist (PR) remover, an etching composition for a packaging process, a cleaner for a packaging process, a wafer adhesive remover, an etchant, a post-etch residue stripper, an ash residue cleaner, a PR residue stripper, a CMP cleaner, a post-CMP cleaner, or the like.

### Metal-containing film etching method and semiconductor device manufacturing method

The metal-containing film may be effectively etched by using the etching composition as described above.

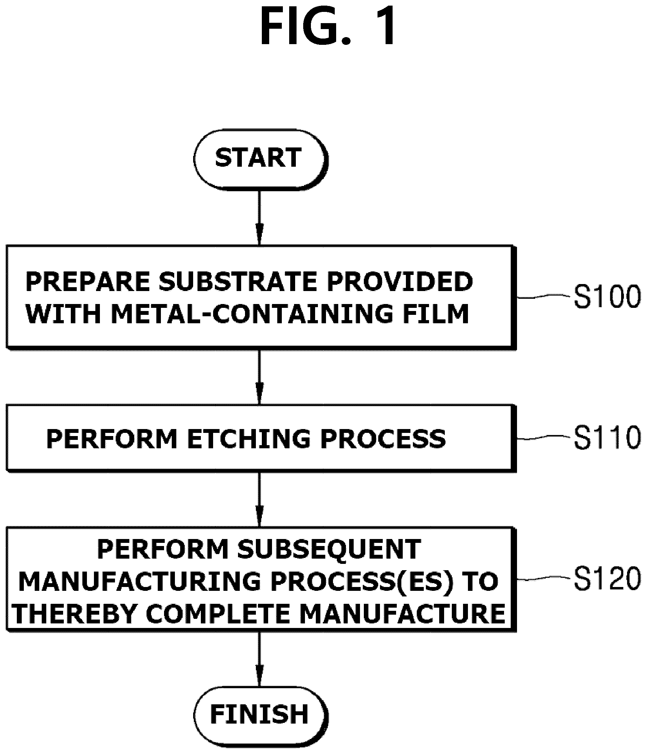

Referring to FIG. 1, a method of etching the metal-containing film, according to an embodiment, may include: preparing a substrate provided with a metal-containing film S100; and performing an etching process of the metal-containing film using the etching composition as described herein to remove at least a portion of the metal-containing film S110.

Details on the metal-containing film may be referred to the descriptions provided herein.

For example, the metal-containing film may include indium (In), titanium (Ti), aluminum (Al), tungsten (W), lanthanum (La), scandium (Sc), gallium (Ga), zinc (Zn), hafnium (Hf), or any combination thereof.

In an embodiment, the metal-containing film may include a metal, a metal nitride, a metal oxide, a metal oxynitride, or a combination thereof.

Since the etching composition includes the copolymer as described above, the etching composition may enhance the productivity and efficiency of the etching process, while having excellent etching selectivity for the metal-containing film. Thus, by using a process of etching the metal-containing film using the etching composition as described above, a semiconductor device with excellent performance may be manufactured.

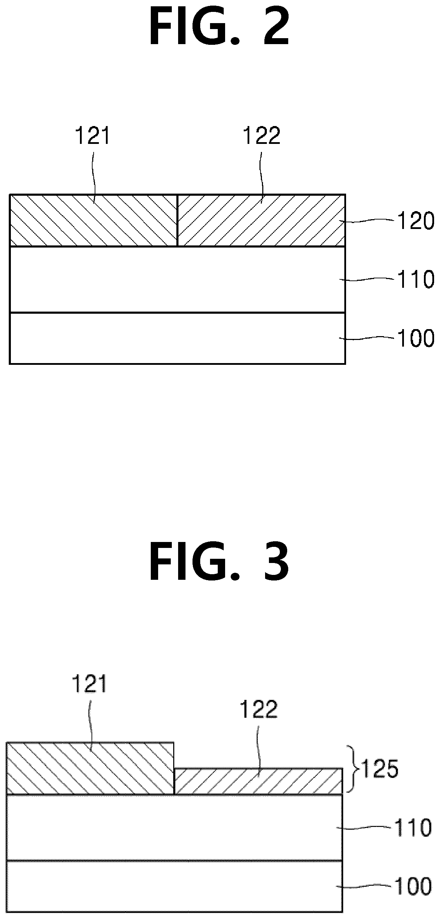

FIGS. 2 and 3 are schematic views for explaining an embodiment of a method of etching a metal-containing film.

Referring to FIG. 2, a substrate 100 provided with a metal-containing film 120 is provided. An interlayer 110 may be disposed between the substrate 100 and the metal-containing film 120. Although not shown in FIG. 2, circuitry elements (e.g., a transistor gate and metal lines), impurity regions, and semiconductor layers may be positioned inside the substrate 100, on the substrate 100, and/or between the substrate 100 and the interlayer 110. According to an embodiment, the metal-containing film 120 may be directly disposed on the substrate 100, and the interlayer 110 may be omitted.

The metal-containing film 120 may include a first region 121 and a second region 122. A second etch rate at which the second region 122 is etched by the etching composition may be higher than a first etch rate at which the first region 121 is etched by the etching composition.

Referring to FIG. 3, the etching composition is used in the etching of the metal-containing film 120 to etch each of at least a portion of the first region 121 and at least a portion of the second region 122, thereby forming a pattern 125 of the metal-containing film. The etching process may be performed by bringing at least a portion of the first region 121 and at least a portion of the second region 122 into contact with the etching composition.

The etching composition may etch each of at least a portion of the first region 121 and at least a portion of the second region 122. In FIG. 3, the pattern 125 of the metal-containing film, formed after etching, includes at least a portion of the second region 122. However, if necessary, various modifications are possible and, for example, the etching process may be performed to completely remove the second region 122 in the pattern 125 of the metal-containing film.

According to an embodiment, the first region 121 may include at least one of a metal oxide (e.g., aluminum oxide), silicon oxide, and tungsten.

According to an embodiment, the second region 122 may include titanium nitride.

According to an embodiment, the second region 122 may include i) titanium nitride, ii) titanium nitride further including indium, aluminum, lanthanum, scandium, gallium, zinc, hafnium, or any combination thereof, or iii) a combination thereof.

According to an embodiment, each of the first region 121 and the second region 122 may include i) titanium nitride, ii) titanium nitride further including indium, aluminum, lanthanum, scandium, gallium, zinc, hafnium, or any combination thereof, or iii) a combination thereof.

According to an embodiment, the first region 121 may include tungsten, and the second region 122 may be tungsten-free.

According to an embodiment, the first region 121 may include tungsten, and the second region 122 may include titanium nitride (TiN).

According to an embodiment, the first region 121 may be a tungsten film, and the second region 122 may be a titanium nitride (TiN) film.

According to an embodiment, an etch rate ratio of the second region 122 to the first region 121 in the etching composition may be in a range of about 5 to about 30, about 5 to about 20, about 5 to about 15, or about 10 to about 15. The etch rate ratio of the second region 122 to the first region 121 may be obtained by dividing the second etch rate at which the second region 122 is etched by the etching composition, by the first etch rate at which the first region 121 is etched by the etching composition. When the etch rate ratio of the second region 122 to the first region 121 in the etching composition is within the above range, the efficiency and productivity of the etching process may be enhanced.

According to an embodiment, the first region 121 may include tungsten, the second region 122 may include a titanium nitride (TiN) film, and the etch rate ratio (hereinafter, referred to as "R(TiN/W)") of the second region 122 to the first region 121 may be in a range of about 5 to about 30, about 5 to about 20, about 5 to about 15, or about 10 to about 15. R(TiN/W) may be obtained by dividing a rate at which the second region 122 including a titanium nitride (TiN) film is etched by the etching composition, by a rate at which the first region 121 including a tungsten film is etched by the etching composition.

Referring to FIG. 1, a method of manufacturing a semiconductor device, according to an embodiment, may include: preparing a substrate provided with a metal-containing film S100; performing an etching process of the metal-containing film using the etching composition S110; and performing subsequent manufacturing process(es) to thereby complete the manufacture of a semiconductor device S120.

### Examples 1 and 2 and Comparative Example 1

Materials listed in Table 1 below were mixed in amounts shown in Table 1 to prepare an etching composition of each of Examples 1 and 2 and Comparative Example 1. In Table 1, the oxidizing agent is hydrogen peroxide, the acid is phosphoric acid, the weight average molecular weight of Polymer 1 is 4000 g/mol, and the remainder of each etching composition corresponds to water (deionized water).

### Evaluation Example 1

The etching composition of Example 1 was added into each of two beakers and heated up to 70 °C, and then a titanium nitride (TiN) film and a tungsten film, which had undergone plasma etching treatment, were immersed in each beaker for 5 minutes. The thicknesses of the TiN film and the tungsten film were then measured by using an ellipsometer (M-2000, J.A.Woolam), a four-point resistance meter, and X-ray fluorescence (XRF), to evaluate an etch rate for the TiN film (Å/min) and an etch rate for the tungsten film (Å/min) of the etching composition of Example 1. Subsequently, R(TiN/W) of the etching composition of Example 1 was evaluated by dividing the etch rate for the TiN film by the etch rate for the tungsten film, and the results thereof are summarized in Table 1.

The above test was repeated using each of the etching compositions of Example 2 and Comparative Example 1, and the results thereof are summarized in Table 1.

**Table 1**

| | Oxidizing agent | Acid | Selective etching inhibitor | | | | TiN film etch rate (Å/min) | Tungsten film etch rate (Å/min) | R (TiN/W) |
|---|---|---|---|---|---|---|---|---|---|
| | Amount (wt%) | Amount (wt%) | Material 1 (Copolymer) | Solid content of Material 1 (wt%) | Material 2 | Amount of Material 2 (wt%) | | | |
| Example 1 | 5 | 60 | 1 | 0.2 | - | - | 43 | 4.1 | 10 |
| Example 2 | 5 | 60 | 1 | 0.15 | A | 0.05 | 45 | 4.0 | 11 |
| Comparative Example 1 | 5 | 60 | - | - | - | - | 44 | 45 | <1 |

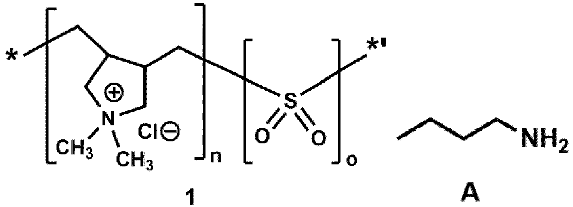

From Table 1, it can be confirmed that the etching compositions of Examples 1 and 2 were able to enhance the efficiency and productivity of an etching process due to having excellent etching selectivity, compared to the etching composition of Comparative Example 1.

According to the one or more embodiments, an etching composition can enhance the productivity and efficiency of an etching process, while having excellent etching selectivity for a metal-containing film, and thus, by using the etching composition, an effective etching process and/or chemical mechanical polishing (CMP) process may be performed on a film to be etched. Therefore, a semiconductor device manufactured through a metal-containing film etching process using the etching composition may have excellent performance.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An etching composition comprising:
an oxidizing agent;
an acid; and
a selective etching inhibitor, wherein
the oxidizing agent is metal-free, and
the selective etching inhibitor comprises a copolymer including a first repeating unit and a second repeating unit,
the first repeating unit is different from the second repeating unit, and
the first repeating unit is a nitrogen-containing repeating unit.

2. The etching composition of claim 1, wherein the oxidizing agent is hydrogen peroxide.

3. The etching composition of claims 1 or 2, wherein an amount of the oxidizing agent is in a range of 0.1 wt% to 50 wt% with respect to 100 wt% of the etching composition; and/or
wherein the acid comprises at least one of phosphoric acid, hydrochloric acid, and chloric acid.

4. The etching composition of any of claims 1-3, wherein the first repeating unit comprises at least one of a repeating unit represented by Formula 1-1 below, a repeating unit represented by Formula 1-2 below, a repeating unit represented by Formula 1-3 below, and a repeating unit represented by Formula 1-4 below: 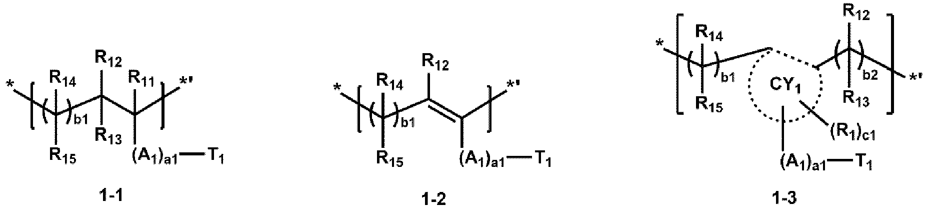 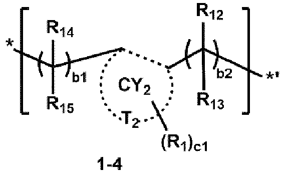
wherein A₁ in Formulae 1-1 to 1-3 is *-C(R₁₆)(R₁₇)-*', *-N(R₁₆)-*', *-C(=O)-*', *-O-*', or *-S-*',
a1 in Formulae 1-1 to 1-3 is an integer from 0 to 20, wherein, when a1 is 2 or greater and less than or equal to 20, at least two of A₁ are identical to or different from each other,
b1 in Formulae 1-1 to 1-4 is an integer from 0 to 10, wherein, when b1 is 2 or greater and less than or equal to 10, at least two of *-C(R₁₄)(R₁₅)-*' are identical to or different from each other,
b2 in Formulae 1-3 and 1-4 is an integer from 0 to 10, wherein, when b2 is 2 or greater and less than or equal to 10, at least two of *-C(R₁₂)(R₁₃)-*' are identical to or different from each other,
T₁ in Formulae 1-1 to 1-3 is *-N(Z₁₁₎(Z₁₂), *-[N(Z₁₁)(Z₁₂)(Z₁₃)⁺[Z₁₄]⁻, a group represented by Formula AN below, or a group represented by Formula BN below, 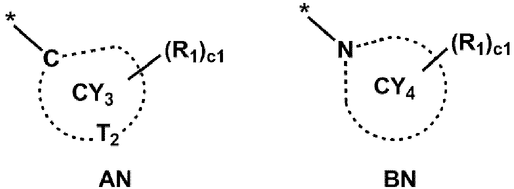
rings CY₁ to CY₄ in Formulae 1-3, 1-4, AN, and BN are each independently a C₂-C₁₀ cyclic group,
c1 in Formulae 1-3, 1-4, AN, and BN is an integer from 0 to 10, wherein, when c1 is 2 or greater and less than or equal to 10, at least two of R₁ are identical to or different from each other,
T₂ in Formulae 1-4 and AN is *-N(Z₁₁)-*' or *-[N(Z₁₁)(Z₁₂)]⁺[Z₁₄]⁻-*',
R₁, R₁₁ to R₁₇, and Z₁₁ to Z₁₃ are each independently :
hydrogen, deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁)(Q₂), *-[N(Q₁)(Q₂)(Q₃)]⁺[Q₄]⁻, or *-(O-CH₂CH₂)ₙ₁-OH; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₁, *-NH-C(=O)-Q₁, *-C(=O)-O-Q₁, *-SO₂-Q₁, *-P(=O)-(Q₁)(Q₂), *-N(Q₁₁)(Q₁₂), *-[N(Q₁₁)(Q₁₂)(Q₁₃)]⁺[Q₁₄]⁻, *-(O-CH₂CH₂)ₙ₁-OH, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
n1 is an integer from 1 to 20,
at least two of R₁, R 11 to R₁₇, and Z₁₁ to Z₁₃ are optionally linked to each other to form a C₂-C₁₀ cyclic group,
Q₁ to Q₃ and Q₁₁ to Q₁₃ are each independently :
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
[Z₁₄]⁻, [Q₄]⁻, and [Q₁₄]⁻ are each an anion, and
* and *' each denote a binding site with a neighboring atom.

5. The etching composition of claim 4, wherein the first repeating unit includes the repeating unit represented by Formula 1-4, and ring CY₂ in Formula 1-4 is a saturated cyclic group having 4, 5, 6, or 7 carbon atoms; and/or
wherein the first repeating unit includes the repeating unit represented by Formula 1-4, and the repeating unit represented by Formula 1-4 is a repeating unit represented by one of Formulae 1-4(1) to 1-4(3), 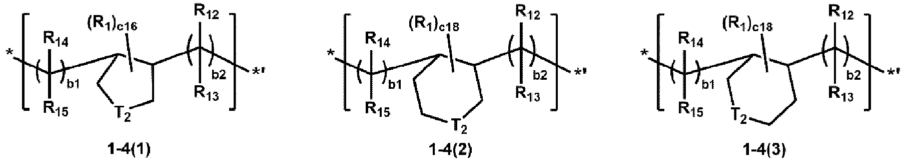
wherein, in Formulae 1-4(1) to 1-4(3),
b1, b2, R₁, R₁₂ to R₁₅, and T₂ are each the same as defined in claim 5,
c16 is an integer from 0 to 6,
c18 is an integer from 0 to 8, and
* and *' each denote a binding site with a neighboring atom.

6. The etching composition of any of claims 1-5, wherein the second repeating unit comprises at least one of a repeating unit derived from a sulfur dioxide-containing compound, a repeating unit derived from an amide-containing compound, and a repeating unit derived from a carboxylic acid-containing compound.

7. The etching composition of any of claims 1-6, wherein the second repeating unit comprises at least one of a repeating unit represented by Formula 2-1 below, a repeating unit represented by Formula 2-2 below, and a repeating unit represented by Formula 2-3 below: 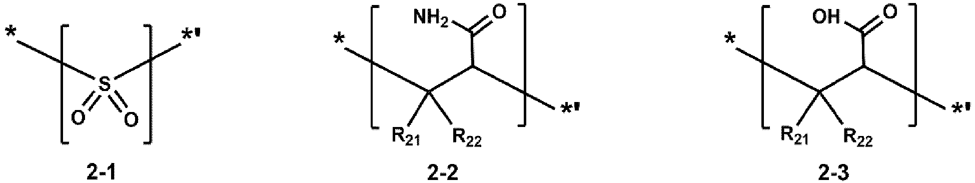
wherein, in Formulae 2-1 to 2-3,
R₂₁ and R₂₂ are each independently :
hydrogen, deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), or *-N(Q₂₁)(Q₂₂); or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-Q₂₁, *-NH-C(=O)-Q₂₁, *-C(=O)-O-Q₂₁, *-SO₂-Q₂₁, *-P(=O)-(Q₂₁)(Q₂₂), *-N(Q₂₁)(Q₂₂), a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof,
Q₂₁ and Q₂₂ are each independently :
hydrogen, deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), or *-N(CH₃)₂; or
a C₁-C₃₀ alkyl group, a C₁-C₃₀ alkoxy group, a C₂-C₃₀ alkenyl group, a C₃-C₃₀ carbocyclic group, or a C₁-C₃₀ heterocyclic group, each unsubstituted or substituted with deuterium, *-F, *-Cl, *-Br, *-I, *-OH, *-SH, *-C(=O)-H, *-C(=O)-OH, *-C(=O)-NH₂, *-C(=O)-NH(CH₃), *-C(=O)-N(CH₃)₂, *-NH-C(=O)-NH₂, *-NH-C(=O)-NH(CH₃), *-NH-C(=O)-N(CH₃)₂, *-NH₂, *-NH(CH₃), *-N(CH₃)₂, a C₁-C₃₀ alkyl group, a C₁-C₃₀ alkoxy group, a C₂-C₃₀ alkenyl group, a C₃-C₃₀ carbocyclic group, a C₁-C₃₀ heterocyclic group, or any combination thereof, and
* and *' each denote a binding site with a neighboring atom.

8. The etching composition of any of claims 1-7, wherein
the copolymer further comprises a third repeating unit, and
the third repeating unit is different from each of the first repeating unit and the second repeating unit.

9. The etching composition of any of claims 1-8, wherein the copolymer comprises at least one of Polymers 1 to 18 below: 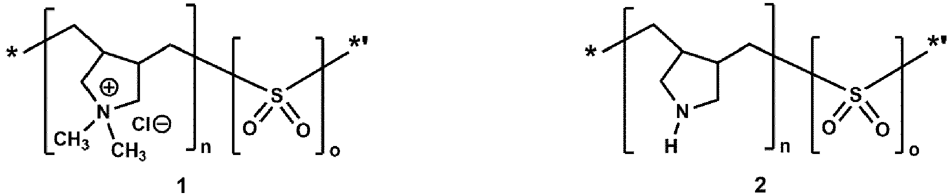 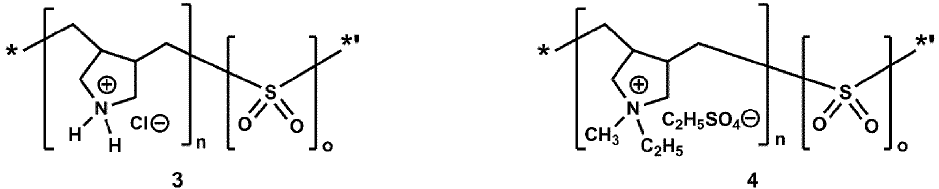 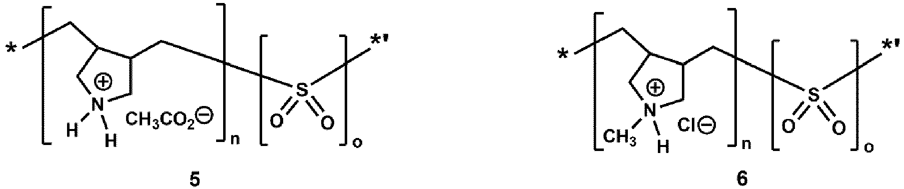 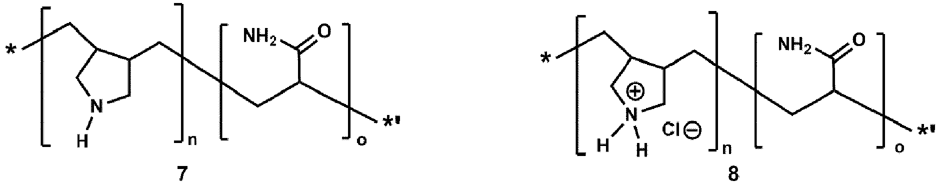 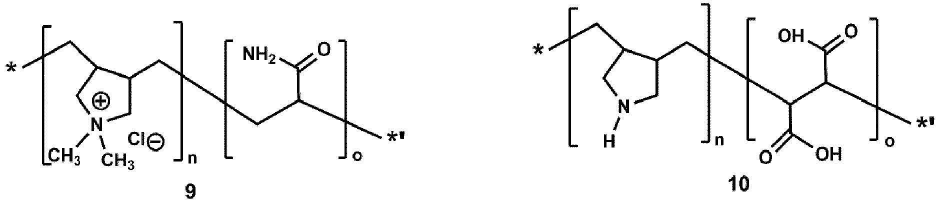 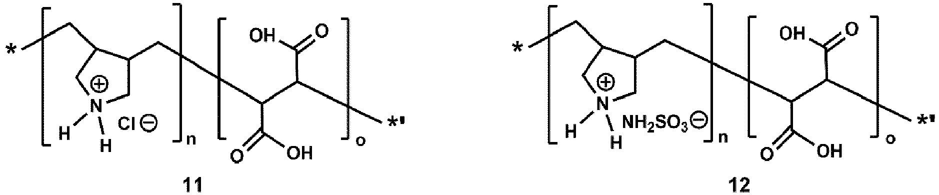 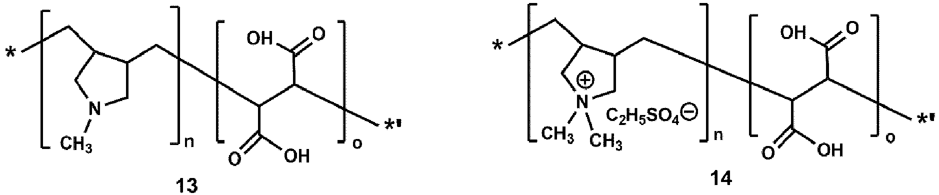 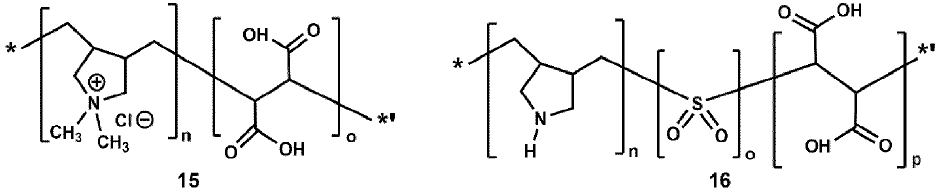 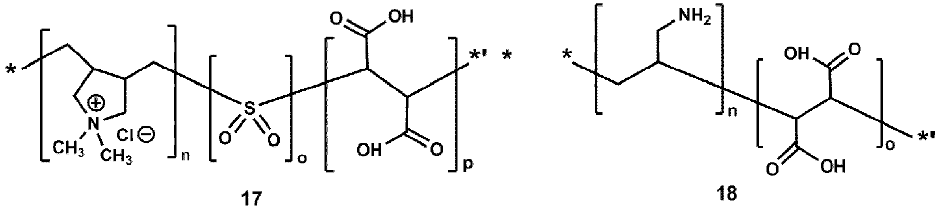
wherein, in Polymers 1 to 18,
n, o, and p are each independently selected from 1 to 10,000, and
* and *' each denote a binding site with a neighboring atom.

10. The etching composition of any of claims 1-9, wherein
the selective etching inhibitor further comprises an amine-containing compound, and
the amine-containing compound is different from the copolymer;
preferably wherein the amine-containing compound comprises an alkylamine, an alkanolamine, or any combination thereof.

11. The etching composition of any of claims 1-10, wherein an amount of the selective etching inhibitor is in a range of 0.001 wt% to 20 wt% with respect to 100 wt% of the etching composition; and/or
wherein the etching composition has a pH of 1.0 to 3.0.

12. A method of etching a metal-containing film, the method comprising:
preparing a substrate provided with a metal-containing film; and
performing an etching process of the metal-containing film using the etching composition of any of claims 1-11 to remove at least a portion of the metal-containing film.

13. The method of claim 12, wherein the metal-containing film comprises indium (In), titanium (Ti), aluminum (Al), tungsten (W), lanthanum (La), scandium (Sc), gallium (Ga), zinc (Zn), hafnium (Hf), or any combination thereof.

14. The method of claims 12 or 13, wherein
the metal-containing film comprises a first region and a second region,
the etching process of the metal-containing film using the etching composition etches the first region at a first etch rate and etches the second region at a second etch rate,
the second etch rate is higher than the first etch rate, and
the etching process includes at least a portion of the first region contacting the etching composition and at least a portion of the second region contacting the etching composition;
preferably wherein
the first region comprises tungsten, and
the second region comprises titanium nitride (TiN).

15. A method of manufacturing a semiconductor device, the method comprising:
etching a metal-containing film according to the method of any of claims 12-14; and
performing one or more subsequent manufacturing processes to thereby complete forming the semiconductor device.
